# EUROPÄISCHE PATENTSCHRIFT

(11) **EP 1 998 418 B1**
(45) Veröffentlichungstag und Bekanntmachung des Hinweises auf die Patenterteilung: **03.11.2010**
(21) Anmeldenummer: 07109247.2
(22) Anmeldetag: 30.05.2007
(51) Int. Cl.: H01S 5/024, H01S 5/40, H01S 5/022

(54) **Lasermodul**
Laser module
Module laser

(43) Veröffentlichungstag der Anmeldung: 03.12.2008
(73) Patentinhaber: iie Gesellschaft für innovative Industrieelektronik mbH, 83564 Soyen (DE)
(72) Erfinder: Kress, Ekkehard, 83512 Wasserburg am Inn (DE)
(74) Vertreter: Oberhardt, Knut

(56) Entgegenhaltungen:
- EP-A- 1 228 834
- US-A- 5 081 637
- US-A- 5 548 605
- US-A- 5 627 850
- US-A- 5 828 683
- US-A1- 2006 007 800

## Beschreibung

Die Erfindung betrifft ein Lasermodul mit mindestens zwei Lasereinheiten nach dem Oberbegriff von Anspruch 1.

Halbleiterdiodenlaser sind heute in vielen Anwendungsbereichen Stand der Technik. Sie besitzen gegenüber anderen Lasertypen den Vorteil, dass sie sich mit bekannter Halbleitertechnologie herstellen lassen, sich leicht in elektronische Schaltungen integrieren lassen, klein sind und einen hohen Wirkungsgrad aufweisen. Dementsprechend vielseitig sind auch ihre Einsatzgebiete, die von der Nachrichtenübertragung über die Verwendung bei optischen Datenspeichern, Druckern bis hin zur Messtechnik reichen. Seit einiger Zeit werden auch in der Materialbearbeitung Halbleiterlaser eingesetzt.

Alle Materialbearbeitungsmethoden mit Lasern, wie Bohren, Schneiden, Schweißen, Löten oder Härten beruhen letztendlich auf der punktgenauen Deponierung von Energie. Dies führt zu einem lokalen Schmelzen oder sogar Verdampfen des Materials. Dazu ist vor allem eine große Laserleistung nötig, wie sie seit einiger Zeit von CO2 oder Nd:YAG-Lasern zur Verfügung gestellt werden kann. Die Ausgangsleistung einer einzelnen emittierenden Laserdiode ist jedoch auf einige 100 mW begrenzt.

Um die Leistung einer Halbleiter-Lasereinheit zu erhöhen, wird das Licht mehrerer Einzellaserdioden zu einem gemeinsamen Strahl zusammengefasst. Eine Möglichkeit besteht darin, eine bestimmte Anzahl an Laserdioden - typisch ist eine Anzahl von 20 bis etwa 80 - mit einem Querschnitt von ca. 1 - 3.5 mm in ihrer pn-Übergangsebene nebeneinander zu einer Gruppe zusammenzufassen. Eine solche Laserdiodengruppe liefert eine Laserleistung von ca. 10-80 Watt. Der Laserstrahl kann mit optischen Mitteln auf einen punkt- oder linienförmigen Querschnitt gebracht werden.

Um die Leistung weiter zu erhöhen werden mehrere dieser Laserdiodengruppen übereinander angeordnet und man erhält so einen Laserbarren mit bis zu 10 cm Länge und einer Leistung von einigen 100 W. Dieser Laserbarren erzeugt einen parallelen Lichtstrahl mit linienförmigem Querschnitt, wobei die Linienbreite in etwa der Höhe des Laserbarrens entspricht. Diese Strahlformung wird über Kollimationslinsen erreicht. Ein Laserbarren wird üblicherweise in einer Lasereinheit mit den entsprechenden elektrischen Anschlüssen untergebracht. Um hohe Leistungen im kW-Bereich erzeugen zu können, werden mehrere dieser Lasereinheiten zu einem Lasermodul zusammengefasst.

Der emittierte Lichtstrahl eines Laserbarrens wird durch ein optisches System in der Lasereinheit so geformt, dass die Linienbreite weiter verringert werden kann. Die durch die einzelnen Lasereinheiten emittierten Lichtstrahlen werden so auf eine Werkstückoberfläche ausgerichtet, dass sie sich überlagern und eine Linie hoher Intensität bilden.

Bei der Anordnung vieler einzelner Laserdioden neben- und übereinander treten jedoch Probleme auf. Zwar haben Halbleiterlaserdioden bereits einen hohen Wirkungsgrad, doch wird immer noch der größte Teil der elektrisch zugeführten Energie in der Laserdiode selbst in Wärme umgesetzt. In Folge erhitzt sich der Laserdiodenbarren stark und, um seine Zerstörung zu vermeiden, muss dieser intensiv gekühlt werden. Dazu sind Wärmesenken vorgesehen, die die Verlustwärme der Laserdioden an ein Kühlmittel abführen. Die Lasereinheiten weisen Öffnungen auf, durch die sie mit Kühlmittel versorgt werden. Wenn nun mehrere Lasereinheiten, deren Laserlicht auf eine Linie ausgerichtet ist, betrieben werden, müssen die einzelnen Lasereinheiten justiert werden können. Bei dieser Justage kann sich die Zufuhr des Kühlmittels als störend erweisen.

Der Erfindung liegt die Aufgabe zugrunde, ein Lasermodul so zu gestalten, dass mehrere Lasereinheiten montiert werden können und dass eine von der Kühlmittelzufuhr unabhängige Justage der einzelnen Lasereinheiten möglich ist. Außerdem sollen die Lasereinheiten auf möglichst geringem Raum untergebracht werden.

Gelöst wird die Aufgabe gemäß der Erfindung durch ein Lasermodul mit den Merkmalen von Anspruch 1. Erfindungsgemäß ist eine Montageeinheit mit wenigstens einer Montagefläche vorgesehen. An diese Montagefläche ist wenigstens eine Lasereinheit mit einer gekrümmten Justierfläche so montiert, dass eine Kühlkanalöffnung in der Justierfläche einer weiteren Kühlkanalöffnung in der Montagefläche gegenüberliegt. Durch diese einander gegenüberliegenden Kühlkanalöffnungen wird das Kühlmittel gepumpt, das zur Kühlung des Laserdiodenbarren benötigt wird. Damit kann auf kühlmittelführende Schläuche verzichtet werden, die zwar ebenfalls eine Justage zulassen würden, aber viel Platz beanspruchen, aufwändig zu montieren sind und insbesondere bei großen Temperatursprüngen schnell zu Undichtigkeiten führen. Durch die Verwendung der Montageeinheit können die einzelnen Lasereinheiten sehr Platz sparend untergebracht werden. Somit dient die Montageeinheit nicht nur als Halter der Lasereinheiten sondern gleichzeitig der Versorgung der Lasereinheiten mit Kühlmittel. In vorteilhafter Weise ist in der Montageeinheit und in jeder Lasereinheit eine Öffnung für die Zufuhr und eine Öffnung für die Abfuhr des Kühlmittels vorgesehen.

In besonders vorteilhafter Weise erfolgt die Dichtung zwischen der Kühlkanalöffnung in der Justierfläche und der Kühlkanalöffnung in der Montagefläche durch eine Ringdichtung. Diese Ringdichtung wird in eine Nut eingelegt, die sich in der Montagefläche befindet. Die Ringdichtung ist in jedem Fall so groß, dass sie die einander gegenüberliegenden Kühlkanalöffnungen in jeder Justierstellung umschließt. Es ist sowohl für die Eingangsals auch die Ausgangsöffnung des Kühlmittels eine eigene Ringdichtung vorgesehen. Die Ringdichtung kann z. B. als Stopfbuchse ausgebildet sein. Da Ringdichtungen im Allgemeinen gemäß kundenspezifischer Anforderungen gefertigt werden, sind sie insbesondere bei geringer Stückzahl sehr teuer.

Besonders vorteilhaft ist die Ringdichtung als O-Ring ausgebildet. O-Ringe erfüllen in vorzüglicher Weise die Abdichtung zwischen zwei Flächen. O-Ringe haben sich für diesen Einsatzfall bewährt. Es gibt sie in den unterschiedlichsten Dimensionen, so dass die Beschaffung eines teuren Werkzeugs entfällt. Auch sind O-Ringe in den unterschiedlichsten Werkstoffen erhältlich, die auf den jeweiligen Einsatzzweck hin optimiert wurden. Damit verspricht der Einsatz von O-Ringen eine lange Haltbarkeit gegen das eingesetzte Kühlmittel und sie sind in der Beschaffung preiswert. Die Ausführung der Nut, in die der O-Ring eingelegt wird, ist rund mit einem in der Regel rechteckigen Querschnitt, der fertigungstechnisch leicht herstellbar ist.

Um die Justage der Lasereinheiten gewährleisten zu können, muss die Verbindung auch dicht sein, wenn die Querschnitte der Kühlkanalöffnungen der Lasereinheit und der Montageeinheit nicht exakt gegenüberliegen. In vorteilhafter Weise weisen die Kühlkanalöffnungen deshalb einen unterschiedlichen Querschnitt auf. Der Unterschied ist so groß, dass der Querschnitt einer Kühlkanalöffnung den Querschnitt der anderen Kühlkanalöffnung über den gesamten Justierbereich völlig überdeckt. Somit ergeben sich in dem Kühlkreislauf, im Besonderen an den Übergängen zwischen der Lasereinheit und der Montageeinheit, keine ungewollten, von der Justierstellung abhängigen Verengungen.

Es ist auch möglich eine Abstufung der Querschnitte in Strömungsrichtung vorzunehmen. So kann der Kühlkanal, der in der Montageeinheit die Kühlflüssigkeit der Lasereinheit zuführt, einen kleineren Querschnitt als der Kühlkanal in der Lasereinheit selbst besitzen. Der Kühlkanalquerschnitt der Lasereinheit am Ausgang zur Montageeinheit ist wiederum kleiner als der Kühlkanalquerschnitt der Montageeinheit selbst. Somit entsteht in Strömungsrichtung des Kühlmittels an den Übergängen zur jeweils anschließenden Einheit eine Querschnittsvergrößerung. Diese Querschnittsvergrößerung verhindert einen Druckanstieg im Bereich der Übergänge, der zu einer erhöhten Belastung des O-Ringes während des Betriebs und damit zu einer verminderten Haltbarkeit führen würde.

Die Montagefläche kann plan ausgebildet sein. Hierzu müssen sich die O-Ringe jedoch an die Krümmung der Justierfläche anpassen und daher stark gegenüber der Montagefläche erhaben sein. Die Dichtheit und die Haltbarkeit der O-Ringe werden hier jedoch Probleme aufwerfen. Die Montagefläche weist daher die gleiche Krümmung wie die Justierfläche auf. Der Vorstand der O-Ringe kann auf diese Weise sehr klein gehalten werden. Um eine zweidimensionale Justage zu ermöglichen, könnte sowohl die Montage- als auch die Justierfläche zweidimensional gekrümmt sein. Für die Justage der hier beschriebenen Linienemitter ist normalerweise jedoch eine Krümmung in einer Richtung ausreichend.

Die Lasereinheiten werden zur Justage vorteilhaft um eine Achse der Montageeinheit geschwenkt. Die Justierfläche und die Montagefläche sind in diesem Fall jeweils als Zylindersegment ausgebildet. Der Radius ist gleich dem Abstand des Achsmittelpunktes zur Montage- bzw. Justierfläche. Die Zu- und Abführung der Kühlflüssigkeit erfolgt hier über zwei Kühlkanäle, die beliebig innerhalb des Zylindersegments liegen können.

Bei der Justage wird die Justierfläche der Lasereinheit relativ zur Montagefläche um die Achse geschwenkt. Durch die oben beschriebene Ausformung der Justier- und der Montagefläche besteht über den gesamten Justierbereich ein flächiger Kontakt zwischen der Montageeinheit und der Lasereinheit. Auch hier zeigt sich, wie vorteilhaft der Einsatz von O-Ringen als Dichtung zwischen den Kühlkanälen der Lasereinheit und der Montageeinheit ist. Die Justage kann auf diese Weise während des Betriebs des Lasermoduls vorgenommen werden. Da die Lasereinheiten durch die Achse in Richtung der Montagefläche gedrückt werden, ist die Dichtheit der O-Ringe auch hier gewährleistet. Selbstverständlich können noch Befestigungsschrauben vorgesehen sein, die die Lasereinheiten nach der Justage in ihrer Stellung fixieren und den Anpressdruck zwischen Justier- und Montagefläche noch erhöhen.

Für die Zufuhr und Abfuhr des Kühlmittels sind ein zentraler Zu- bzw. Ablauf vorgesehen. Da die zuführenden Kanäle untereinander an dem zentralen Zulauf angeschlossen sind, herrschen vor den zuführenden Kanälen in dem zentralen Zulauf unterschiedliche Druckverhältnisse und es ist möglich, dass durch die einzelnen Lasereinheiten unterschiedlich viel Kühlmittel strömt. Das führt dazu, dass die einzelnen Lasereinheiten unterschiedlich gekühlt werden. Eine unterschiedliche Kühlung wiederum führt zu einer unterschiedlichen optischen Leistung der einzelnen Lasereinheiten. In vorteilhafter Weise ist der Durchfluss für jede Lasereinheit individuell einstellbar.

In besonders vorteilhafter Weise erfolgt die Durchflusseinstellung des Kühlmittels über eine einstellbare Drossel. Diese Drosseln befinden sich am Anschluss der einzelnen Kühlkanäle an dem zentralen Zulauf. Die Drosseln verfügen über eine Düsennadel, die über ein Gewinde relativ zu einer Düse verstellt wird. Diese Nadel verengt oder erweitert den Kühlkanalquerschnitt in der Düse. Hierdurch ist es nun möglich, den Volumenstrom an Kühlmittel, der durch jede einzelne Lasereinheit fließt, genau einzustellen.

Um die Einstellung kontrollieren zu können, sind Sensoren vorgesehen. Diese Sensoren sind mit der Montageeinheit verbunden und befinden sich in Strömungsrichtung gesehen hinter jeder Lasereinheit. Somit kann die pro Zeiteinheit durchgesetzte Kühlmittelmenge kontrolliert und überwacht werden. In besonders vorteilhafter Weise handelt es sich hier um Durchflussmesser. Die Festinstallation der Durchflussmesser hat weiter den Vorteil, dass die Durchflussmenge evtl. später nachgestellt oder nach einem Austausch einer Lasereinheit neu eingestellt werden kann.

Bei einer vorteilhaften Ausgestaltung der Erfindung ist das Lasermodul so aufgebaut, dass ein möglichst gleichmäßiges linienförmiges Strahlungsbild erzeugt werden kann. Hierzu sind die einzelnen Lasereinheiten in dem Lasermodul so gegeneinander versetzt angeordnet, dass die Mittelpunkte der Strahlungsbilder der Laserdioden der einen Lasereinheit zwischen den Mittelpunkten der Strahlungsbilder der Laserdioden der anderen Lasereinheit angeordnet sind. Dies gilt insbesondere bei dem Einsatz identischer Lasereinheiten. Es können jedoch auch unterschiedliche Lasereinheiten montiert werden. Diese unterschiedlichen Lasereinheiten müssen dann so aufgebaut sein, dass sich bereits durch die Anordnung der Laserbarren in der jeweiligen Lasereinheit der angestrebte Versatz der Strahlungsbilder der Laserdioden ergibt. In diesem Fall können die Lasereinheiten ohne Versatz exakt übereinander montiert werden.

Weitere Einzelheiten und Vorteile der Erfindung ergeben sich aus den Unteransprüchen im Zusammenhang mit der Beschreibung eines Ausführungsbeispiels, das anhand der Zeichnung eingehend erläutert wird.

Es zeigt:

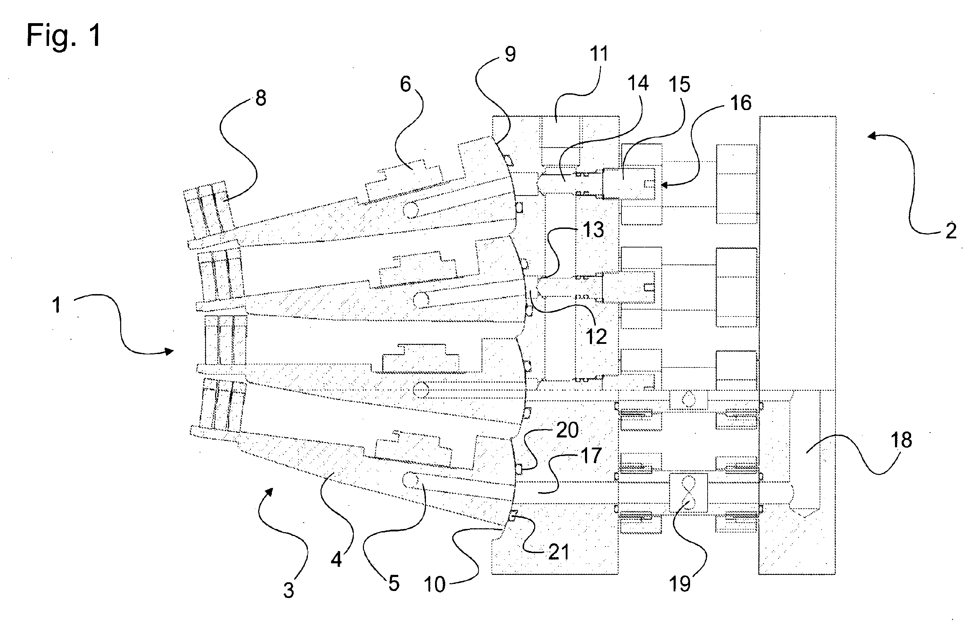

- Fig. 1: einen Querschnitt der Montageeinheit mit montierten Lasereinheiten.

Fig. 1 zeigt ein Lasermodul 1, das eine Montageeinheit 2 und vier daran montierte Lasereinheiten 3 aufweist. Die Lasereinheit 3 zeigt einen Grundkörper 4, in dem Kühlkanäle 5 verlaufen, einen auf dem Grundkörper 4 montierten Laserdiodenbarren 6 und eine Sammellinsenoptik 8. Der Grundkörper 4 weist an der der Sammellinsenoptik 8 gegenüberliegenden Seite eine gekrümmte Justierfläche 9 auf, die vollflächig auf einer gleich gekrümmten Montagefläche 10 aufliegt. Die Montagefläche 10 ist Bestandteil der Montageeinheit 2. Die Lasereinheit 3 ist in der Nähe der Sammellinsenoptik 8 durch eine hier nicht dargestellte Achse schwenkbar gelagert und durch hier nicht dargestellte Schrauben im Bereich der Justier- 9 und Montagefläche 10 lösbar fixiert.

Jede gekrümmte Justier- 9 und Montagefläche 10 ist als Zylindersegment ausgebildet. Der Radius entspricht hierbei der Entfernung der Schwenkachse zur Justier- 9 bzw. Montagefläche 10.

In der Montageeinheit 2 befindet sich ein zentraler Kühlmittelzulauf 11. Von dem zentralen Kühlmittelzulauf 11 zweigen vier zuführende Kühlkanäle 12 ab, die zu den einzelnen Montageflächen 10 führen. Der Eingang des zuführenden Kühlkanals 12 wird durch eine Düse 13 gebildet, in die eine Düsennadel 14 ragt. Diese Düsennadel 14 ist mit einer Einstellschraube 15 unlösbar verbunden. Die Düsennadel 14 und die Einstellschraube 15 bilden die Hauptbestandteile einer Drossel 16.

Von jeder Montagefläche 10 führt ein abführender Kühlkanal 17 zu einem zentralen Kühlmittelablauf 18. Dieser zentrale Kühlmittelablauf 18 ist ebenfalls Bestandteil der Montageeinheit 2. Der Verlauf des abführenden Kühlkanals 17 wird durch einen Durchflussmesser 19 unterbrochen.

In den Montageflächen 10 befindet sich um jede Öffnung der zuführenden 12 und abführenden Kühlkanäle 17 eine runde Nut 20 mit einem rechteckigen Querschnitt, in die ein O-Ring 21 eingelegt ist.

Die Laserdiodenbarren 6 der Lasereinheit 2 emittieren Licht, das durch die direkt vorgeschaltete Kollimationslinse parallel gerichtet wird. Anschließend passiert das Laserlicht eine Sammellinsenoptik 8, die das Laserlicht zu einer schmalen Linie formt.

Die durch die Laserdiodenbarren 6 erzeugte Wärme wird an das in den Kühlkanälen 5 des Grundkörpers 4 zirkulierende Kühlmittel abgegeben. Das kalte Kühlmittel wird in den zentralen Kühlmittelzulauf 11 der Montageeinheit 2 eingespeist und von dort auf die einzelnen zuführenden Kühlkanäle 12 verteilt. Von dort gelangt das immer noch kalte Kühlmittel in die Kühlkanäle 5 des Grundkörpers 4. Nach der Aufnahme der Verlustwärme der Laserdiodenbarren 6 strömt die warme Kühlflüssigkeit durch die abführenden Kühlkanäle 17 der Montageeinheit 2 in den zentralen Kühlmittelablauf 18.

Da die optische Leistung der Lasereinheit 3 davon abhängt, wie viel Wärme abgeführt wird, wird der Volumenstrom des Kühlmittels für jede Lasereinheit 3 individuell eingestellt. Hierzu wird im zuführenden Kühlkanal 12 der Öffnungsquerschnitt zwischen der Düsennadel 14 und der Düse 13 mittels der Einstellschraube 15 so eingestellt, dass durch jede Lasereinheit 3 die gleiche Menge an Kühlmittel pro Zeiteinheit strömt. Um dies zu verifizieren, befindet sich in jedem abführenden Kühlkanal 17 ein Durchflussmesser 19.

In vorteilhafter Weise erfolgt die Abdichtung der einander gegenüberliegenden Öffnungen der Kühlkanäle 5 des Grundkörpers 4, der zuführenden 12 und der abführenden Kühlkanäle 17, die das unter Druck stehende Kühlmittel führen, durch O-Ringe 21, die in einer Nut 20 der Montagefläche 10 liegen.

Zur Justage des Lasermoduls 1 werden hier nicht gezeigte Fixiermittel, z. B. Schrauben, gelöst und die Lasereinheiten 2 so um die Schwenkachse gedreht, bis die Strahlen aller Lasereinheiten 3 auf einer Linie auf der Werkstückoberfläche zusammentreffen. Da die Krümmung der Justagefläche 9 und der Montierfläche 10 gleich geformt ist, verändert sich der Abstand zwischen der Montageeinheit 2 und Lasereinheit 3 während des Schwenkvorganges nicht. Da die Lasereinheiten 3 zur Justage betriebsbereit sein müssen und bereits mit Kühlmittel beaufschlagt sind, dichtet der O-Ring 21 auch während des Schwenkens so zuverlässig ab, dass ein Austritt von Kühlmittel im Bereich des O-Rings 21 nicht erfolgt. Die Öffnungen der Kühlkanäle 5 des Grundkörpers 4, der zuführenden 12 und der abführenden Kühlkanäle 17 sind so dimensioniert, dass der Querschnitt der einen Öffnung den Querschnitt der ihr gegenüberliegenden Öffnung über den gesamten Justierbereich vollflächig überdeckt. Dadurch kommt es nicht zu ungewollten Einengungen im Bereich der Kühlkanäle. Dies könnte ansonsten zu einem Anstieg des Drucks auf die O-Ringe 21 führen und eine Leckage, gerade während der Justage, herbeiführen. In vorteilhafter Weise wird die Justage der Lasereinheiten vor dem Einstellen der Durchflussmenge des Kühlmittels durch die einzelnen Lasereinheiten 3 vorgenommen.

Die Montage mehrerer Lasereinheiten 3 auf eine Montageeinheit 2 führt zu einer äußerst Platz sparenden Anordnung. Der Einsatz von O-Ringen 21 als Dichtung ersetzt die ansonsten notwendigen kühlmittelführenden Schläuche oder Leitungen. Dies alles führt zu einem äußerst kompakten und leistungsstarken Lasermodul 1.

### Bezugszeichenliste:

- 1: Lasermodul
- 2: Montageeinheit
- 3: Lasereinheit
- 4: Grundkörper
- 5: Kühlkanal der Lasereinheit
- 6: Laserdiodenbarren
- 8: Sammellinsenoptik
- 9: Justierfläche
- 10: Montagefläche
- 11: zentraler Kühlmittelzulauf
- 12: zuführender Kühlkanal
- 13: Düse
- 14: Düsennadel
- 15: Einstellschraube
- 16: Drossel
- 17: abführender Kühlkanal
- 18: zentraler Kühlmittelablauf
- 19: Durchflussmesser
- 20: Nut
- 21: O-Ring

## Patentansprüche

1. Lasermodul (1) mit mindestens zwei Lasereinheiten (3), wobei die optischen Strahlenachsen der mindestens zwei Lasereinheiten (3) zusammentreffen,
die mindestens zwei Lasereinheiten (3) Kühlkanäle (5) aufweisen, die mit einem Kühlmittel versorgt werden, und
eine Montageeinheit (2) mit wenigstens einer Montagefläche (10) für die mindestens zwei Lasereinheiten (3) vorgesehen ist,
**dadurch gekennzeichnet, dass**
wenigstens eine Lasereinheit (3) mit einer gekrümmten Justierfläche (9) an der wenigstens einen Montagefläche (10) der Montageeinheit (2) montiert ist, wobei eine Kühlkanalöffnung in der Justierfläche (9) der wenigstens einen Lasereinheit (3) einer weiteren Kühlkanalöffnung in der wenigstens einen Montagefläche (10) der Montageeinheit (2) gegenüberliegt.

2. Lasermodul nach Anspruch 1, **dadurch gekennzeichnet, dass** die Dichtung zwischen der Kühlkanalöffnung in der Justierfläche (9) der wenigstens einen Lasereinheit (3) und der Kühlkanalöffnung in der wenigstens einen Montagefläche (10) der Montageeinheit (2) durch eine Ringdichtung (21) erfolgt.

3. Lasermodul nach Anspruch 2, **dadurch gekennzeichnet, dass** die Ringdichtung als O-Ring (21) ausgebildet ist.

4. Lasermodul nach Anspruch 1, **dadurch gekennzeichnet, dass** die Kühlkanalöffnungen in der gekrümmten Justierfläche (9) und in der wenigstens einen Montagefläche (10) einen unterschiedlichen Querschnitt aufweisen.

5. Lasermodul nach Anspruch 4, **dadurch gekennzeichnet, dass** der Querschnitt einer Kühlkanalöffnung so dimensioniert ist, dass er den Querschnitt der anderen Kühlkanalöffnung über den gesamten Justierbereich vollflächig überdeckt.

6. Lasermodul nach Anspruch 1, **dadurch gekennzeichnet, dass** die wenigstens eine Montagefläche (10) der Montageeinheit (2) die gleiche Krümmung wie die Justierfläche (9) der wenigstens einen Lasereinheit (3) aufweist.

7. Lasermodul nach Anspruch 1, **dadurch gekennzeichnet, dass** der Durchfluss des Kühlmittels für jede Lasereinheit (3) individuell einstellbar ist.

8. Lasermodul nach Anspruch 7, **dadurch gekennzeichnet, dass** die Durchflusseinstellung des Kühlmittels über eine Drossel (16) erfolgt.

9. Lasermodul nach Anspruch 7, **dadurch gekennzeichnet, dass** die Kontrolle der Durchflusseinstellung über einen Sensor (19) erfolgt.

10. Lasermodul nach Anspruch 8, **dadurch gekennzeichnet, dass** der Sensor ein Durchflussmesser (19) ist.

11. Lasermodul nach Anspruch 1, **dadurch gekennzeichnet, dass** die mindestens zwei Lasereinheiten (3) mehrere nebeneinander angeordnete Laserbarren mit mehreren Laserdioden aufweisen.

12. Lasermodul nach Anspruch 11, **dadurch gekennzeichnet, dass** die Lasereinheiten (3) so angeordnet und/oder aufgebaut sind, dass die Mittelpunkte der Strahlungsbilder der Laserdioden der einen Lasereinheit zwischen den Mittelpunkten der Strahlungsbilder der Laserdioden der anderen Lasereinheit angeordnet sind.

## Claims

1. A laser module (1), comprising at least two laser units (3), wherein
the optical beam axes of the at least two laser units (3) meet,
the at least two laser units (3) comprise cooling channels (5), which are supplied with a cooling medium, and
a mounting unit (2) with at least one mounting surface (10) for the at least two laser units (3) is provided,
**characterized in that**
at least one laser unit (3) with a curved adjustment surface (9) is mounted on the at least one mounting surface (10) of the mounting unit (2), wherein a cooling channel opening in the adjustment surface (9) of the at least one laser unit (3) faces another cooling channel opening in the at least one mounting surface (10) of the mounting unit (2).

2. The laser module according to claim 1, **characterized in that** sealing between the cooling channel opening in the adjustment surface (9) of the at least one laser unit (3) and the cooling channel opening in the at least one mounting surface (10) of the mounting unit (2) is by means of a ring seal (21).

3. The laser module according to claim 2, **characterized in that** the ring seal is formed as an O-ring (21).

4. The laser module according to claim 1, **characterized in that** the cooling channel openings in the curved adjustment surface (9) and in the at least one mounting surface (10) have different cross-sections.

5. The laser module according to claim 4, **characterized in that** the cross-section of one cooling channel opening is dimensioned in such a manner that it covers the entire cross-section of the other cooling channel opening over the entire adjustment range.

6. The laser module according to claim 1, **characterized in that** the at least one mounting surface (10) of the mounting unit (2) has the same curvature as the adjustment surface (9) of the at least one laser unit (3).

7. The laser module according to claim 1, **characterized in that** the flow rate of the cooling medium is individually adjustable for each laser unit (3).

8. The laser module according to claim 7, **characterized in that** the flow rate adjustment of the cooling medium is achieved by means of a throttle (16).

9. The laser module according to claim 7, **characterized in that** the flow rate adjustment is monitored by means of a sensor (19).

10. The laser module according to claim 8, **characterized in that** the sensor is a flow meter (19).

11. The laser module according to claim 1, **characterized in that** the at least two laser units (3) comprise a plurality of laser bars arranged side by side and comprising a plurality of laser diodes.

12. The laser module according to claim 11, **characterized in that** the laser units (3) are arranged and/or structured in such a manner that the center points of the beam spots of the laser diodes of one laser unit are arranged between the center points of the beam spots of the laser diodes of the other laser unit.

## Revendications

1. Module laser (1) avec au moins deux unités laser (3), dans lequel les axes des rayons optiques des au moins deux unités laser (3) se rencontrent, les au moins deux unités laser (3) présentent des canaux de refroidissement (5) qui sont pourvus d'un agent réfrigérant, et une unité de montage (2) avec au moins une surface de montage (10) pour les au moins deux unités laser (3) est prévue, **caractérisé en ce que** au moins une unité laser (3) avec une surface d'ajustage coudée (9) est montée sur la au moins une surface de montage (10) de l'unité de montage (2), dans lequel une ouverture du canal de refroidissement dans la surface d'ajustage (9) de la au moins une unité laser (3) se trouve en face d'une autre ouverture de canal de refroidissement dans la au moins une surface de montage (10) de l'unité de montage (2).

2. Module laser selon la revendication 1, **caractérisé en ce que** l'étanchéité entre l'ouverture du canal de refroidissement dans la surface d'ajustage (9) de la au moins une unité laser (3) et l'ouverture du canal de refroidissement dans la au moins une surface de montage (10) dans la surface d'ajustage coudée (9) et dans la au moins une surface de montage (10) est réalisée par un joint annulaire (21).

3. Module laser selon la revendication 2, **caractérisé en ce que** le joint annulaire est conçu comme joint torique (21).

4. Module laser selon la revendication 1, **caractérisé en ce que** les ouvertures du canal de refroidissement dans la surface d'ajustage coudée (9) et dans la au moins une surface de montage (10) présentent une section transversale différente.

5. Module laser selon la revendication 4, **caractérisé en ce que** la section transversale d'une ouverture de canal de refroidissement est dimensionnée de manière telle qu'elle recouvre entièrement la section transversale de l'autre ouverture de canal de refroidissement sur la zone d'ajustage totale.

6. Module laser selon la revendication 1, **caractérisé en ce que** la au moins une surface de montage (10) de l'unité de montage (2) présente le même coude que la surface d'ajustage (9).

7. Module laser selon la revendication 1, **caractérisé en ce que** le débit de l'agent réfrigérant pour chaque unité laser (3) est réglable individuellement.

8. Module laser selon la revendication 7, **caractérisé en ce que** le réglage du débit de l'agent réfrigérant est réalisé au moyen d'une soupape d'étranglement (16).

9. Module laser selon la revendication 7, **caractérisé en ce que** le contrôle du réglage du débit est réalisé au moyen d'un capteur (19).

10. Module laser selon la revendication 8, **caractérisé en ce que** le capteur est un débitmètre (19).

11. Module laser selon la revendication 1, **caractérisé en ce que** les au moins deux unités laser (3) présentent plusieurs barres laser disposées les unes à côté des autres avec plusieurs diodes laser.

12. Module laser selon la revendication 11, **caractérisé en ce que** les unités laser (3) sont disposées et/ou structurées de manière telle que les centres des images de rayonnement des diodes laser d'une unité laser sont disposés entre les centres des images de rayonnement des diodes laser de l'autre unité laser.
